# EUROPÄISCHE PATENTANMELDUNG

(11) **EP 0 735 691 A2**
(43) Veröffentlichungstag der Anmeldung: **02.10.1996**
(21) Anmeldenummer: 96104812.1
(22) Anmeldetag: 26.03.1996
(51) Int. Cl.: H03L 7/00

(54) **Phasenregelungsschaltung für Resolvererregung bei digitalen Steuerungen**

(30) Priorität: 31.03.1995 DE 19512171
(71) Anmelder: SIEMENS AKTIENGESELLSCHAFT, 80333 München (DE)
(72) Erfinder: Donat, Albrecht, Dipl.-Ing., 91462 Dachsbach (DE); Schweigert, Ralf, Dipl.-Ing. (FH), 91325 Adelsdorf (DE)

(57) **Zusammenfassung**

Um bei einer digitalen Steuerung (DS) die Resolversignale (A,B) im Reglertakt (Tdi,TsADi) erfassen zu können, synchronisiert eine Phasenregelungsschaltung das Resolvererregersignal (E) mit dem Reglertakt. Dafür muß die Frequenz des Erregersignals (E) ein ganzzahliges Vielfaches der Frequenz des Reglertakts (Tdi) sein. Die Phasenregelungsschaltung ermittelt ein Zeitsignal (Z), das den Maxima der Resolversignale (A,B) entspricht, und bewirkt damit eine Frequenzverstimmung des Erregersignals (E), die wiederum eine regelnde Phasenverschiebung der Resolversignale (A,B) nach Art einer Phase Loocked Loop bewirkt.

## Beschreibung

Die Erfindung bezieht sich auf eine digitale Steuerung mit einem Reglertakt und mit mindestens einem, von einem periodischen Erregersignal abgeleiteten, analogen Signal, wie z.B. bei einem Resolver und bezieht sich insbesondere auf eine Phasenregelungsschaltung bei einer solchen digitalen Steuerung.

Digitale Steuerungen, z.B. zur Lage- und Drehzahlregelung, müssen analoge Meßsignale in den vorbestimmten Abständen des Reglertaktes unter Zuhilfenahme eines Analog/Digital-Wandlers (A/D-Wandler) als digitale Werte erfassen. Als Meßsignale sind beispielsweise die Ausgangssignale eines Resolvers zu verstehen, wie diese bereits aus DE-A-89 10 564 bekannt sind.

Bei Erregung mit einem Erregersignal gibt ein Resolver zwei gegenüber dem Erregersignal phasenverschobene analoge Resolversignale aus, deren Amplituden dem Resolverrotorlagewinkel entsprechen. Dabei handelt es sich beim Erregersignal und den beiden Resolversignalen um Wechselstromsignale. Diese analogen Wechselstromsignale werden von einem A/D-Wandler in entsprechende digitale Werte gewandelt und der digitalen Steuerung zugeführt. Um beim Digitalisieren solcher Wechselstromsignale eine ausreichende Genauigkeit zu realisieren, muß ein Resolversignal zu dem Zeitpunkt innerhalb seiner Wechselstromperiode festgehalten werden und dem A/D-Wandler zugeführt werden, zu dem es sein Maximum annimmt. Die A/D-Wandlung selbst nimmt auch eine gewisse Zeit in Anspruch, bevor ein dem Resolversignal entsprechender digitaler Wert zur Verfügung steht.

Es entsteht somit das Problem der Synchronisation zwischen den Zeitpunkten, zu denen die digitale Steuerung die digitale Auswertung der analogen Resolversignale erfassen will, und den Zeitpunkten (Wechselstromsignalmaxima), zu denen diese sich am besten erfassen lassen und tatsächlich, z.B. am Ausgang des A/D-Wandlers, zur Verfügung stehen.

Die bisherige Lösung bestand meist darin, auf eine Synchronisation zu verzichten, was aber eine Vielzahl an Nachteilen mit sich bringt. Bei einer Asynchronität der Resolver-Erregersignalfrequenz zum Reglertakt der digitalen Steuerung entstehen durch die Abtastung der Resolversignale zu den Signalmaxima unerwünschte Schwebungseffekte, die sich in einer reduzierten Lage- und Drehzahlgenauigkeit wiederspiegeln und die entsprechend in Kauf genommen werden mußten. Zudem ist der Prozessor mit dem Anstoßen jeder neuen Resolver-Wertermittlung belastet. Es kann außerdem noch zu unerwünschten Totzeiten kommen, wenn die digitale Auswertung eines analogen Resolversignals nicht rechtzeitig am Ausgang eines A/D-Wandlers zur Verfügung steht.

Aufgabe der Erfindung ist es, eine digitale Steuerung und insbesondere eine Phasenregelungsschaltung der eingangs genannten Art so auszubilden,
- daß sie eine Erfassung der Resolversignale im Reglertakt erlaubt, ohne den Prozessor zusätzlich zu belasten,
- daß sie unabhängig ist von der Phasenverschiebung zwischen dem Erregersignal und den Resolversignalen und
- daß sie die Resolversignale rechtzeitig abtasten kann, damit z.B. ein A/D-Wandler mit der Signaldigitalisierung vor dem nächsten Reglertakt fertig ist.

Gemäß der Erfindung wird diese Aufgabe dadurch gelöst, daß die Frequenz des Erregersignals ein ganzzahliges Vielfaches der Frequenz des Reglertakts der digitalen Steuerung ist und daß eine Phasenregelungsschaltung das Erregersignal mit dem Reglertakt der digitalen Steuerung synchronisiert.

Die Phasenregelungsschaltung ist so ausgelegt, daß eine erste Schaltung das Maximum des analogen Signals ermittelt und ein entsprechendes Zeitsignal an eine zweite Schaltung ausgibt und daß die zweite Schaltung in Abhängigkeit des Zeitsignals über eine vom Reglertakt der digitalen Steuerung getaktete Frequenzverstimmung des Erregersignals eine regelnde Phasenverschiebung des analogen Signals bewirkt.

Die Phasenverschiebung des Erregersignals bewirkt, daß der Zeitpunkt der Verfügbarkeit des digitalen Gegenwertes des analogen Signals, z.B. an den Ausgängen eines Analog/Digital-Wandlers, den Zugriffszeitpunkten der digitalen Steuerung auf den digitalen Gegenwert entspricht. Auf diese Weise wird die Phasenverschiebung zwischen dem Erregersignal und den Resolversignalen ausgeglichen und die Resolversignale können im Moment ihres Signalmaximums zu dem Zeitpunkt abgetastet werden, der nötig ist, damit ein A/D-Wandler mit der Signaldigitalisierung vor dem nächsten Reglertakt fertig ist. Totzeiten werden dadurch vermieden.

Eine vorteilhafte Weiterbildung der Erfindung besteht darin, daß die Frequenz des Erregersignals ein ganzzahliges Vielfaches der Frequenz des Takts der digitalen Steuerung ist. Das hat den Vorteil, daß das Erregersignal auf einfache Weise direkt vom Takt und insbesondere dem Reglertakt der digitalen Steuerung abgeleitet werden kann und führt zu einer weiteren vorteilhafte Ausgestaltung der Erfindung, die darin besteht, daß in der zweiten Schaltung das Zeitsignal über ein vom Takt der digitalen Steuerung getaktetes Halteglied zu einem Modulo-"n"-Zähler geführt wird, wobei "n" der maximale Zählerstand ist. Der Modulo-"n"-Zähler verkörpert das Verhältnis eines ganzzahligen Vielfachen zwischen Erregerfrequenz und der Frequenz der digitalen Steuerung.

Die zweite Schaltung kann auch das Zeitsignal dazu verwenden, den maximalen Zählerstand "n" des Modulo-"n"-Zählers zu verändern. Auf diese Weise entsteht eine PLL-Schaltung ("Phase Locked Loop"), die das Erregersignal mit dem Reglertakt der digitalen Steuerung nach Einpendeln der Reglerschleife synchronisiert.

Eine weiter vorteilhafte Weiterbildung der Erfindung besteht darin, daß ein A/D-Wandler vom Zeitsignal angestoßen wird und das analoge Signal in einen digitalen Gegenwert wandelt. Eine solche Schaltung ist besonders einfach, weil das Zeitsignal bereits vorhanden ist und der Prozessor der Steuerung nicht zusätzlich mit expliziten Synchronisierungsaufgaben, wie z.B. das Anstoßen des A/D-Wandlers, belastet wird.

Ferner ist es vorteilhaft, daß ein Verzögerungsglied einen verzögerten Takt vom Reglertakt ableitet und mit diesem verzögerten Takt das, dem Modulo-"n"-Zähler vorgeschaltete, Halteglied taktet. Dadurch entspricht der Zeitpunkt der Verfügbarkeit des digitalen Gegenwertes des analogen Signals, z.B. an den Ausgängen eines Analog/Digital-Wandlers, dem Takt, in dem die digitale Steuerung auf den digitalen Gegenwert zugreifen muß.

Eine weitere vorteilhafte Weiterbildung der Erfindung besteht aus einer dritten Schaltung, die die positive und/oder negative Halbwelle des Erregersignals ermittelt und als Hilfssignal an einen ersten Umkodierer weiterleitet. Mit dem Hilfssignal kann der Umkodierer die positiven und/oder negativen Halbwellen des analogen Signals identifizieren. Dabei ergibt sich eine besonders einfache Ausgestaltung, wenn die dritte Schaltung das Maximum des Erregersignals ermittelt.

Bei einer weiteren Ausgestaltung der Erfindung sind zwei analoge Signale vorhanden, deren variable Amplituden eine Phasenverschiebung von 90 Grad zu einander aufweisen und ein erster Umkodierer stellt fest, in welchem Phasenbereich sich die Signale momentan befinden. Bei digitalen Steuerungen geben Resolver üblicherweise derartige Signale aus. Auf diese Weise läßt sich die oft problematische Digitalisierung von Signalen mit kleiner Amplitude vermeiden.

Ferner ist es aus Gründen einer einfachen Schaltungstechnik möglich, daß ein zweiter Umkodierer für jeden Phasenbereich der Signale ein provisorisches Zeitsignal erzeugt, daß von einem Multiplexer eines dieser Zeitsignale als eigentliches Zeitsignal ausgewählt wird und, daß dieser Multiplexer vom ersten Umkodierer mit dem festgestellten Phasenbereich angesteuert wird.

Eine besonders vorteilhafte Ausgestaltung ergibt sich ferner, wenn eine Schaltung die beiden Signale gleichrichtet, vergleicht und das Vergleichssignal und den ersten Umkodierer weiterleitet. Dieser kann dann an Hand des Vergleichssignals feststellen, welches der beiden Resolversignale momentan die größere Amplitude aufweist.

Eine weitere vorteilhafte Ausgestaltung der Erfindung besteht darin, daß die erste Schaltung vom analogen Signal ein phasenverschobenes zweites Signal ableitet, so daß der Zeitpunkt des Maximums des analogen Signals dann auftritt, wenn das in der Phase verschobene Signal seinen Nulldurchgang aufweist.

Ein Ausführungsbeispiel der Erfindung ist in den Zeichnungen dargestellt und wird im folgenden näher erläutert. Dabei zeigen:
- FIG 1: ein Blockschaltbild zur Phasenregelung der Resolvererregung in einer digitalen Steuerung,
- FIG 2a: eine Tabelle, die für jeden Bereich des Resolverrotorlagewinkels angibt, welches der beiden Resolversignale A, B die größere Amplitude aufweist,
- FIG 2b: eine Tabelle, die für jede Kombination der binären Resolversignale Ad, Bd, und deren Vergleichssignal Cd angibt, in welchem Bereich sich der Resolverrotorlagewinkel befindet,
- FIG 3: erfindungsgemäße Signalverläufe in der der digitale Steuerung,
- FIG 4: erfindungsgemäße Signalverläufe in den verschiedenen Bereichen des Resolverrotorlagewinkels.

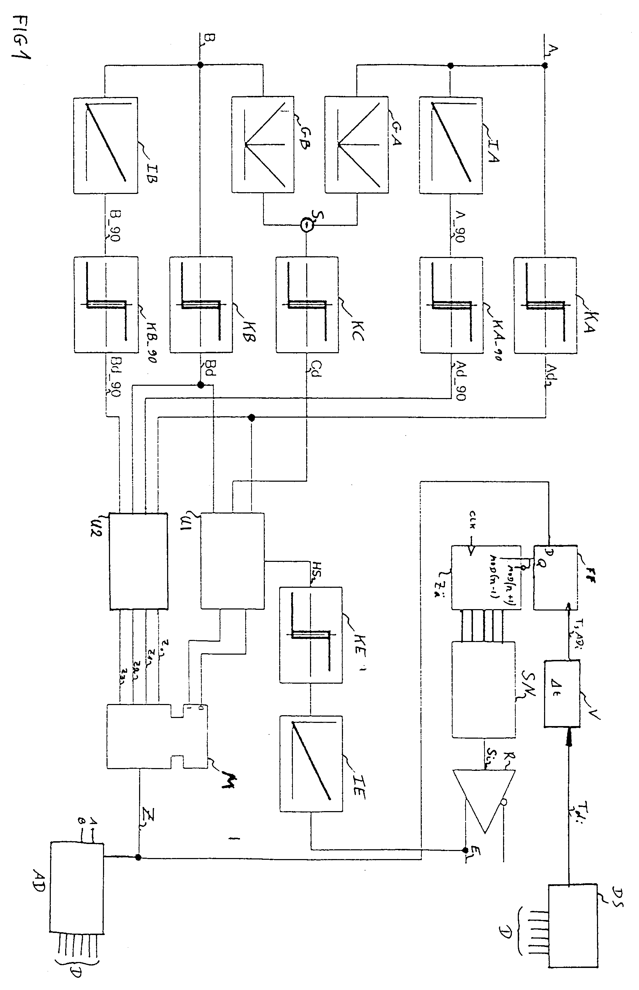

Ein Ausführungsbeispiel gemaß FIG 1 der Erfindung ist ein Schaltkreis zur Phasenregelung der Resolvererregung E eines Resolvers, der zwei analoge Resolversignale A und B ausgibt. Dabei werden die analogen Resolversignale A und B auch einem A/D-Wandler AD zugeführt, der ein entsprechendes digitales Signal D an die digitale Steuerung DS weitergibt.

Das analoge Resolversignal A wird auch folgenden Schaltelementen zugeführt :
- über einen Komparator KA wird es in ein binäres Signal Ad gewandelt,
- über einen Integrator IA wird es zunächst zum Signal A_90, das um 90 Grad in der Phase verschoben ist, bevor es über einen Komparator KA_90 zu einem binären Signal Ad_90 gewandelt wird. Die binären Signale Ad und Ad_90 werden den Umkodierern U1 und U2 zugeführt.

Das Resolversignal wird B genau so geschaltet, wie das Resolversignal A. Das analoge Resolversignal wird B folgenden Schaltelementen zugeführt:
- über einen Komparator KB wird es in ein binäres Signal Bd gewandelt,
- über einen Integrator IB wird es zunächst zum Signal B_90, das um 90 Grad in der Phase verschoben ist, bevor es über einen Komparator KB_90 zu einem binären Signal Bd_90 gewandelt wird. Die binären Signale Bd und Bd_90 werden den Umkodierern U1 und U2 zugeführt.

Die analogen Resolversignale A und B werden auch jeweils von einen Gleichrichter GA, bzw. GB gleichgerichtet und zu einem Differenzsignal C in der Schaltung S subtrahiert. Dieses Differenzsignal wird über einen Komparator KC zu einem binären Signal Cd geformt, das wiederum dem Umkodierer U1 zugeführt wird.

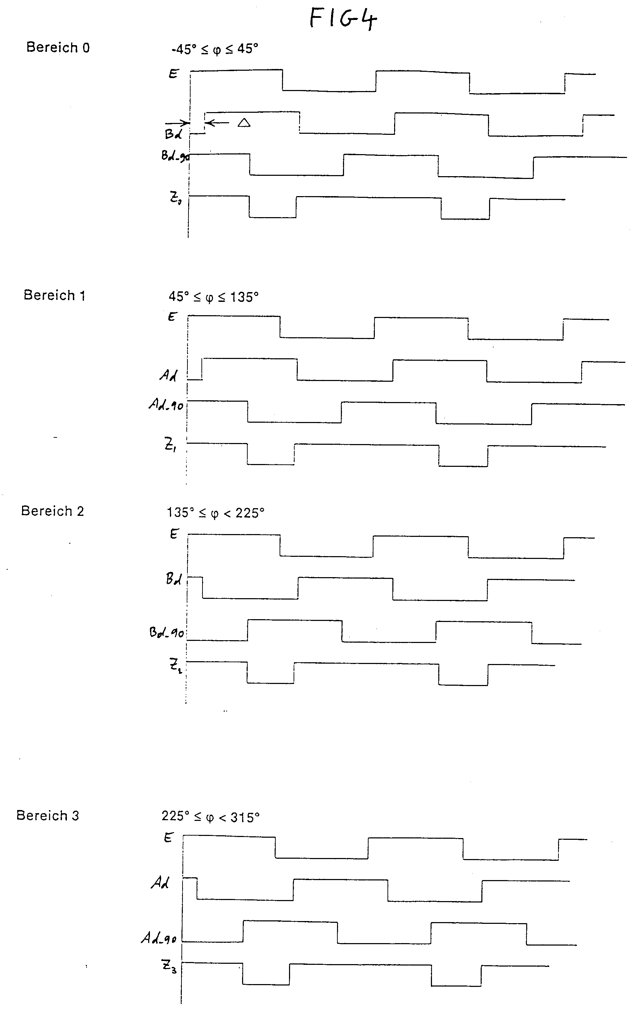

Der Umkodierer U2 bekommt die binären Signale Ad, Ad_90, Bd und Bd_90 und berechnet die provisorischen Zeitsignale Z0 und Z2 aus einer logischen Verknüpfung von Bd und Bd_90 und die provisorischen Zeitsignale Z1 und Z3 aus einer logischen Verknüpfung von Ad und Ad_90 (siehe auch FIG 4). Unterschiedliche logische Verknüpfungen werden benötigt in Abhängigkeit davon, ob sich die Signale in ihrer positiven oder negativen Halbwelle befinden: In jeder Halbwelle hat nur eines der beiden Signale Z0 und Z2, bzw. Z1 und Z2 Gültigkeit. Die vier provisorischen Zeitsignale Z0 bis Z3 werden an einen Multiplexer M weitergeleitet.

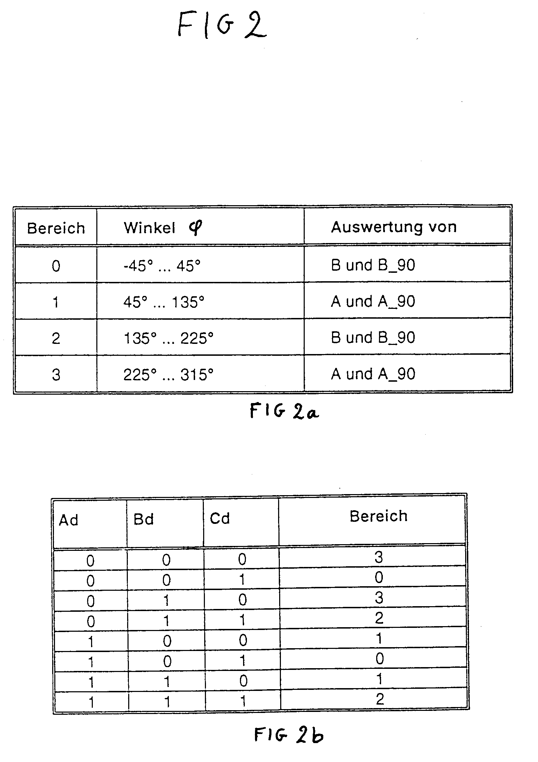

Der Umkodierer U1 bekommt die binären Signale Ad, Bd und Cd und ein binäres Hilfssignal HS. Das Hilfssignal HS dient dazu, die positiven und negativen Halbwellen der Signale zu identifizieren. Es kann z.B. vom Resolvererregersignal E über einen Integrator IE und einem Komparator KE abgeleitet werden. In diesem Fall hat das Hilfssignal HS den binären Wert 1 in der positiven Halbwelle des Erregersignals E und ist gegenüber diesem um 90 Grad phasenverschoben. Der Umkodierer U1 entscheidet, in welchem von vier Phasenbereichen "0", "1", "2" oder "3" sich die Resolversignale A und B momentan befinden. Dies geschieht nach der in FIG 2b gezeigten Tabelle, wo jeder Wertekombination der binären Signale Ad, Bd und Cd ein Bereich zugeordnet ist.
Die Phasenbereiche 0 bis 3 entsprechen verschiedenen Resolverrotorlagewinkeln Phi und sind in der Tabelle von FIG 2a aufgeführt. Die Phasenbereiche geben auch an, welches der beiden Resolversignale A oder B momentan die größere Amplitude hat, bzw. ob Ad und Ad_90 oder Bd und Bd_90 insbesondere für eine A/D-Wandlung vorzuziehen sind. Dies ist aus der letzten Spalte der Tabelle von FIG 2a zu entnehmen. Die Phasenbereiche sind noch weiter unterteilt, je nachdem, ob sich die Signale A und B in ihren positiven oder negativen Halbwellen befinden, so daß insgesamt vier Phasenbereiche 0 bis 3 zu unterscheiden sind.

Der Multiplexer M bekommt den vom Umkodierer U1 ermittelten Phasenbereich 0 bis 3 und schaltet das entsprechende provisorische Zeitsignal Z0 bis Z3 durch zum eigentlichen Zeitsignal Z.

Dieses Zeitsignal Z kann einem A/D-Wandler AD zugeführt werden, damit die Wandlung zum Zeitpunkt des Maximums der Resolversignale stattfinden kann. Das Zeitsignal Z wird auch an den Dateneingang eines Halteglieds (Flip-Flop) FF weitergeleitet.

Das Halteglied FF wird von einem Takt TsADi getaktet. Der Takt TsADi ist ein über ein Verzögerungsglied V vom Reglertakt Tdi der digitalen Steuerung durch Verzögerung abgeleiteter Takt. Das Ausmaß der Verzögerung Delta-t ist so gewählt, daß eine zum Zeitpunkt Z, bzw. TsADi angestoßene A/D-Wandlung der Resolversignale rechtzeitig zum nächstfolgenden Reglertakt Tdi+1 zur Verfügung steht.

Der Datenausgang Q des Halteglieds FF ist mit einem Modulo-"n"-Zähler Zä verbunden. Der Modulo-"n"-Zähler Zä zählt die Taktimpulse einer Systemuhr CLK. Wenn der Zählerstand n-1 erreicht, schaltet der Modulo-"n"-Zähler Zä weiter auf 0 und beginnt von neuem. Der Zählerstand des Modulo-"n"-Zählers Zä ist mit einem Sinus Netzwerk SN verbunden, welches die suksessiven Zählerstände in ein sinusartiges Signal Si verwandelt und über eine Glättungs- und Verstärker-Stufe R das Resolvererregungssignal E liefert.

Wie schon angedeutet, leitet das Halteglied FF im Takt TsADi den Wert des Zeitsignals Z weiter an den Modulo-"n"-Zähler Zä, wo es den maximalen Zählerstand "n" um einen Wert "k" herauf oder herunter setzt. Im in FIG 1 gezeigten Ausführungsbeispiel ist k = 1. Ein herauf- oder heruntersetzen des maximalen Zählerstands erhöht oder reduziert die Frequenz des vom Sinus Netzwerk SN und der Glättungs- und Verstärker-Stufe R produzierte Resolvererregungssignal E. Eine Erhöhung der Resolverfrequenz E bewirkt, daß die Resolversignale A und B ihre Maxima früher erreichen und daher das Zeitsignal Z auch früher erzeugt wird. Eine Reduzierung der Resolverfrequenz E bewirkt, daß die Resolversignale A und B ihre Maxima später erreichen und daher das Zeitsignal Z auch später erzeugt wird. Wenn bei einem verfrühten Zeitsignal Z der Zählerstand erhöht wird und bei einem verspäteten Zeitsignal Z der Zählerstand reduziert wird, hat man eine Phase Locked Loop (PLL), bei der sich die Erregerfrequenz des Resolvers so einpendelt, daß das Zeitsignal Z genau synchron zum Takt TsADi der digitalen Steuerung entsteht. Wenn Z und TsDAi zeitgleich sind, hat die Phasenregelungsschaltung das Erregersignal E mit dem Reglertakt der digitalen Steuerung synchronisiert. Der Prozessor der digitalen Steuerung wird hierbei nicht mit zusätzlichen Synchronisierungsaufgaben belastet. Die entstandene Synchronisation ist von der Phasenverschiebung zwischen dem Erregersignal E und den Resolversignalen A, B unabhängig.

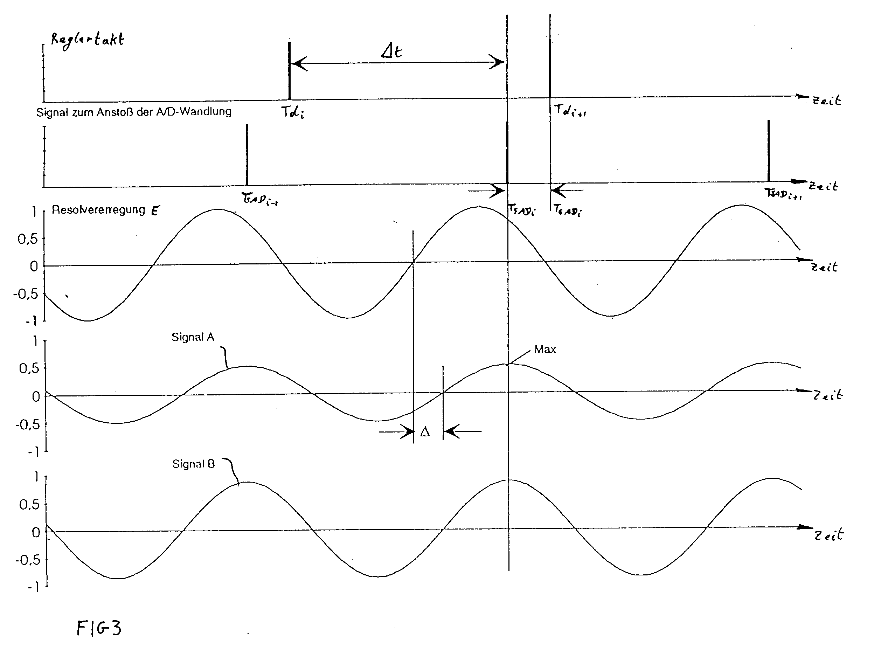

Eine digitale Erfassung der Resolversignale kann im Reglertakt stattfinden, wobei die Resolversignale rechtzeitig abgetastet werden können, damit z.B. ein A/D-Wandler mit der Signaldigitalisierung vor dem nächsten Reglertakt fertig ist. In der Darstellung gemäß FIG 3 sind fünf Signalverläufe der digitale Steuerung abgebildet. Die waagerechte Achse stellt die Zeit und die senkrechte Achse die Signalamplitude dar. Von oben nach unten gesehen, sind aufgezeigt:
- der digitale Reglertakt Td der digitalen Steuerung mit suksessiven Taktimpulsen Tdi und Tdi+1,
- der durch Verzögerung mit Ausmaß Delta-t vom Reglertakt Tdi ableitete, digitale Takt TsADi mit suksessiven Taktimpulsen TsADi-1, TsADi, TsADi+1 mit zusätzlich beim Impuls TsADi gezeigter A/D-Wandlungszeit TeADi wobei die Impulse TsADi den Zeitpunkten entsprechen, zu denen ein A/D-Wandler mit Wandlungszeit TeADi angestoßen werden sollte, um rechtzeitig zum Reglertakt Tdi mit der Digitalisierung fertig zu sein,
- die analoge Resolvererregung E,
- das analoge Resolversignal A, das ein Maximum Max synchron zum Taktimpuls TsADi aufweist, und das gegenüber der Resolvererregung E um das Ausmaß Delta in der Phase verschoben ist,
- das analoge Resolversignal B, das ebenfalls ein Maximum Max synchron zum Taktimpuls TsADi aufweist, und das gegenüber der Resolvererregung E um das gleiche Ausmaß Delta in der Phase verschoben ist.

In der Darstellung gemaß FIG 4 sind die wichtigsten Signalverläufe in den Bereichen 0, 1, 2, und 3 des Resolverrotorlagewinkels aufgezeigt. Die waagerechte Achse stellt die Zeit und die senkrechte Achse die Signalamplitude dar. Von oben nach unten gesehen, sind aufgezeigt :

Der Bereich 0 für Resolverrotorlagewinkel zwischen -45 Grad und +45 Grad

Die oberste Spur ist ein binäres Signal, das der der Resolvererregung E entspricht und nur zur Referenz gezeigt ist. Die darunter liegende Spur entspricht dem binären Resolversignal Bd, das gegenüber der Resolvererregung E um das Ausmaß Delta in der Phase verschoben ist. Die nochmals darunter liegende Spur entspricht dem um 90 Grad in der Phase verzögertem binären Bd_90. Die unterste Spur für den Bereich 0 entspricht dem provisorischen Zeitsignal Z0, das durch logische Verknüpfung der Signale Bd und Bd_90 erzeugt wird. Das Signal Z0 hat eine abfallende Flanke, die dem Zeitpunkt des Nulldurchgangs des Signals Bd_90 entspricht, bzw. dem Zeitpunkt des Signalmaximums des analogen Resolversignals B entspricht. Das provisorische Zeitsignal Z0 bleibt dann für eine gewisse Zeit, z.B. eine viertel Periode, niedrig, bevor es wieder auf hoch umschaltet.

Der Bereich 1 für Resolverrotorlagewinkel zwischen 45 Grad und 135 Grad

Die oberste Spur ist ein binäres Signal, das der der Resolvererregung E entspricht und nur zur Referenz gezeigt ist. Die darunter liegende Spur entspricht dem binären Resolversignal Ad, das gegenüber der Resolvererregung E um das Ausmaß Delta in der Phase verschoben ist. Die nochmals darunter liegende Spur entspricht dem um 90 Grad in der Phase verzögertem binären Ad_90. Die unterste Spur für den Bereich 1 entspricht dem provisorischen Zeitsignal Z1, das durch logische Verknüpfung der Signale Ad und Ad_90 erzeugt wird. Das Signal Z1 hat eine abfallende Flanke, die dem Zeitpunkt des Nulldurchgangs des Signals Ad_90 entspricht, bzw. dem Zeitpunkt des Signalmaximums des analogen Resolversignals A entspricht. Das provisorische Zeitsignal Z1 bleibt dann für eine gewisse Zeit, z.B. eine viertel Periode, niedrig, bevor es wieder auf hoch umschaltet.

Der Bereich 2 für Resolverrotorlagewinkel zwischen 135 Grad und 225 Grad

Die oberste Spur ist ein binäres Signal, das der der Resolvererregung E entspricht und nur zur Referenz gezeigt ist. Die darunter liegende Spur entspricht dem binären Resolversignal Bd, das gegenüber der Resolvererregung E um das Ausmaß Delta in der Phase verschoben ist. Die nochmals darunter liegende Spur entspricht dem um 90 Grad in der Phase verzögertem binären Bd_90. Die unterste Spur für den Bereich 2 entspricht dem provisorischen Zeitsignal Z2, das durch logische Verknüpfung der Signale Bd und Bd_90 erzeugt wird. Das Signal Z2 hat eine abfallende Flanke, die dem Zeitpunkt des Nulldurchgangs des Signals Bd_90 entspricht, bzw. dem Zeitpunkt des Signalminimums des analogen Resolversignals B entspricht. Das provisorische Zeitsignal Z2 bleibt dann für eine gewisse Zeit, z.B. eine viertel Periode, niedrig, bevor es wieder auf hoch umschaltet.

Der Bereich 3 für Resolverrotorlagewinkel zwischen 225 Grad und 315 Grad

Die oberste Spur ist ein binäres Signal, das der der Resolvererregung E entspricht und nur zur Referenz gezeigt ist. Die darunter liegende Spur entspricht dem binären Resolversignal Ad, das gegenüber der Resolvererregung E um das Ausmaß Delta in der Phase verschoben ist. Die nochmals darunter liegende Spur entspricht dem um 90 Grad in der Phase verzögertem binären Ad_90. Die unterste Spur für den Bereich 3 entspricht dem provisorischen Zeitsignal Z3, das durch logische Verknüpfung der Signale Ad und Ad_90 erzeugt wird. Das Signal Z3 hat eine abfallende Flanke, die dem Zeitpunkt des Nulldurchgangs des Signals Ad_90 entspricht, bzw. dem Zeitpunkt des Signalminimums des analogen Resolversignals A entspricht. Das provisorische Zeitsignal Z3 bleibt dann für eine gewisse Zeit, z.B. eine viertel Periode, niedrig, bevor es wieder auf hoch umschaltet.

Da die abfallende Flanke der provisorischen Zeitsignale dem Zeitpunkt des Signalmaximums des analogen Signals entspricht, eignet sie sich dazu, eine A/D-Wandlung des analogen Signals anzustoßen. Selbstverständlich könnten die provisorischen Zeitsignale auch so gestaltet werden, daß sie eine ansteigende Flanke zum Zeitpunkt des entsprechenden analogen Signalmaximas aufweisen. Das Ausschlaggebende ist nur, daß das Minimum und das Maximum des analogen Signals erkannt werden kann.

## Patentansprüche

1. Digitale Steuerung (DS) mit Reglertakt (Tdi) und mit mindestens einem, von einem periodischen Erregersignal (E) abgeleiteten analogen Signal (A, B), wie z.B. bei einem Resolver **dadurch gekennzeichnet**, daß die Frequenz des Erregersignals (E) ein ganzzahliges Vielfaches der Frequenz des Reglertakts (Tdi) der digitalen Steuerung (DS) ist und daß eine Phasenregelungsschaltung (IA,IB,KA,KB, U1,U2,M,V,FF,Zä,SN,R) das Erregersignal (E) mit dem Reglertakt (Tdi) der digitalen Steuerung synchronisiert.

2. Phasenregelungsschaltung, insbesondere für eine digitale Steuerung (DS) nach Anspruch 1, **dadurch gekennzeichnet**, daß eine erste Schaltung (IA,IB,KA,KB,U1, U2, M) das Maximum des analogen Signals (A,B) ermittelt und ein entsprechendes Zeitsignal (Z) an eine zweite Schaltung (FF,Zä,SN) ausgibt und daß die zweite Schaltung (FF,Zä, SN) in Abhängigkeit des Zeitsignals (Z) über eine vom Reglertakt (Tdi) der digitalen Steuerung getaktete Frequenzverstimmung des Erregersignals (E) eine regelnde Phasenverschiebung des analogen Signals (A, B) bewirkt.

3. Phasenregelungsschaltung nach Anspruch 2, **dadurch gekennzeichnet**, daß in der zweiten Schaltung das Zeitsignal (Z) über ein vom Takt (Tdi) der digitalen Steuerung (DS) getaktetes Halteglied (FF) zu einem Modulo-"n"-Zähler (Zä) geführt wird, wo "n" der maximale Zählerstand ist.

4. Phasenregelungsschaltung nach einem der vorhergehenden Ansprüche 2 bis 3, **dadurch gekennzeichnet**, daß die zweite Schaltung das Zeitsignal (Z) dazu verwendet, den maximalen Zählerstand "n" eines Modulo-"n"-Zählers (Zä) zu verändern.

5. Phasenregelungsschaltung nach einem der vorhergehenden Ansprüche 2 bis 4, **dadurch gekennzeichnet**, daß die Frequenz des Erregersignals (E) ein ganzzahliges Vielfaches der Frequenz des Takts (Tdi) der digitalen Steuerung (DS) ist.

6. Phasenregelungsschaltung nach einem der vorhergehenden Ansprüche 2 bis 5, **dadurch gekennzeichnet**, daß ein Analog/Digital-Wandler (AD) vom Zeitsignal (Z) angestoßen wird und das analoge Signal (A, B) in einen digitalen Gegenwert (D) wandelt.

7. Phasenregelungsschaltung nach Anspruch 6, **dadurch gekennzeichnet**, daß ein Verzögerungsglied (V) einen verzögerten Takt (TsADi) vom Reglertakt (Tdi) ableitet und mit diesem verzögerten Takt (TsDAi) das dem Modulo-"n"-Zähler (Zä) vorgeschaltete Halteglied (FF) taktet.

8. Phasenregelungsschaltung nach einem der vorhergehenden Ansprüche 2 bis 7, **gekennzeichnet** durch eine dritte Schaltung (IE,KE), welche die positive und/oder negative Halbwelle des Erregersignals (E) ermittelt und als Hilfssignal (HS) an einen ersten Umkodierer (U1) weiterleitet.

9. Phasenregelungsschaltung nach einem der vorhergehenden Ansprüche 2 bis 8, **dadurch gekennzeichnet**, daß zwei analoge Signale (A,B) vorhanden sind, deren variable Amplituden eine Phasenverschiebung von 90 Grad zueinander aufweisen und daß der erste Umkodierer (U1) feststellt, in welchen Phasenbereichen sich die Signale (A,B) momentan befinden.

10. Phasenregelungsschaltung nach Anspruch 9, **dadurch gekennzeichnet**, daß ein zweiter Umkodierer (U2) für jeden Phasenbereich der Signale (A,B) ein provisorisches Zeitsignal (Z0,Z1,Z2,Z3) erzeugt, daß von einem Multiplexer (M) eines dieser Zeitsignale als eigentliches Zeitsignal (Z) ausgewählt wird und daß dieser Multiplexer (M) vom ersten Umkodierer (U1) mit dem festgestellten Phasenbereich angesteuert wird.
